# EUROPÄISCHE PATENTANMELDUNG

(11) **EP 4 757 178 A1**
(43) Veröffentlichungstag der Anmeldung: **10.06.2026**
(21) Anmeldenummer: 25220053.0
(22) Anmeldetag: 02.12.2025
(51) Int. Cl.: H03F 3/45, H03F 3/30

(54) **OPERATIONSVERSTÄRKER MIT HAUPT- UND NEBENSIGNALPFAD**

(30) Priorität: 03.12.2024 DE 102024135835
(71) Anmelder: Universität Stuttgart, 70174 Stuttgart (DE)
(72) Erfinder: Grözing, Markus, 70176 Stuttgart (DE); Nägele, Raphael, 70806 Kornwestheim (DE); Finkbeiner, Jakob, 70771 Leinfelden-Echterdingen (DE)
(74) Vertreter: Gagel, Roland

(57) **Zusammenfassung**

Der vorgeschlagene Operationsverstärker weist wenigstens eine erste Verstärkerschaltung (1.1, 1.2, 1.3, 1.4) in einem Hauptsignalpfad zwischen Eingangsanschlüssen und einem oder zwei Ausgangsanschlüssen des Operationsverstärkers auf. Vom Hauptsignalpfad zweigt zwischen den Eingangsanschlüssen und der ersten Verstärkerschaltung (1.1, 1.2, 1.3, 1.4) ein Nebensignalpfad ab, in dem eine zweite Verstärkerschaltung (3) ausgebildet ist und der in der ersten Verstärkerschaltung (1.1, 1.2, 1.3, 1.4) wieder mit dem Hauptsignalpfad zusammengeführt wird. Die erste und die zweite Verstärkerschaltung (1.1, 1.2, 1.3, 1.4, 3) sind so dimensioniert, dass die Signalbandbreite des Hauptsignalpfades um einen Faktor von mindestens 10 größer als die Signalbandbreite des Nebensignalpfades ist und die zweite Verstärkerschaltung (3) einen geringeren Eingangs-Offset als die erste Verstärkerschaltung (1.1, 1.2, 1.3, 1.4) aufweist. Damit lässt sich ein Operationsverstärker mit einer kleinen eingangs-bezogenen Offset-Fehlerspannung bei gleichzeitig schnellem und breitbandigem Hauptsignalpfad und geringer Leistungsaufnahme realisieren.

## Beschreibung

### Technisches Anwendungsgebiet

Die vorliegende Erfindung betrifft einen Operationsverstärker, der wenigstens eine Verstärkerschaltung in einem Hauptsignalpfad von Eingangsanschlüssen zu einem oder zwei Ausgangsanschlüssen des Operationsverstärker aufweist und sich in schnellen Regelschleifen einsetzen lässt.

Die Anforderungen an Operationsverstärker (OP) in schnellen Regelschleifen für energieeffiziente Anwendungen umfassen unter anderem einen schnellen (also breitbandigen) Signalpfad, eine geringe Leistungsaufnahme sowie eine kleine eingangsbezogene Eingangsoffset-Fehlerspannung. Für eine kleine eingangsbezogene Eingangsoffset-Fehlerspannung, welche aus der Fehlanpassung zwischen den Parametern der Eingangstransistoren (z.B. MOS-Feldeffektransistoren (MOSFETs) oder Bipolartransistoren (BJTs)) resultiert, sind Eingangstransistoren mit sehr großer Kanal- bzw. Gate- oder Emitter-Fläche notwendig. Große Eingangstransistoren bei gleichzeitig schnellem Signalpfad erfordern allerdings einen großen Strom im Arbeitspunkt, weswegen die Anforderungen nach geringer Verlustleistung nicht mehr erfüllt werden können.

### Stand der Technik

Zur Lösung dieser Problematik ist es bekannt, das sog. "Offset-Sampling" anzuwenden. Dabei wird in einer initialen Kalibrationsphase der Ausgang des Operationsverstärkers mit einem der Eingänge kurzgeschlossen. Aufgrund der hohen Spannungsverstärkung des Operationsverstärkers stellt sich dabei am Eingang die Eingangs-Offsetspannung ein. Diese Spannung wird auf einem Kondensator gespeichert und im weiteren Betrieb seriell zum Eingangssignal geschaltet. Durch diese Maßnahme wird der eingangsbezogene Offset kompensiert. Aufgrund des Leckstroms des Kondensators muss das Offset-Sampling allerdings periodisch wiederholt werden.

Für das Offset-Sampling ist daher ein getakteter Betrieb des Operationsverstärkers erforderlich, wie er beispielsweise in sog. Switched-Capacitor-Schaltungen (SC) verwendet wird. Hierfür ist eine aufwändige Taktsteuerung mit nicht überlappenden Taktsignalen notwendig. Viele Anwendungen erfordern allerdings einen rein zeitkontinuierlichen Betrieb der Regelschaltungen und damit auch der Operationsverstärker. Für derartige Anwendungen kann daher das Offset-Sampling nicht eingesetzt werden.

Die Aufgabe der vorliegenden Erfindung besteht darin, eine Operationsverstärkerschaltung anzugeben, mit der ein schneller Operationsverstärker für den Einsatz in schnellen Regelschleifen realisiert werden kann, der eine geringe eingangsbezogene Offset-Fehlerspannung sowie eine geringe Leistungsaufnahme aufweist.

### Darstellung der Erfindung

Die Aufgabe wird mit dem Operationsverstärker gemäß Patentanspruch 1 gelöst. Vorteilhafte Ausgestaltungen des Operationsverstärkers sind Gegenstand der abhängigen Patentansprüche oder lassen sich der nachfolgenden Beschreibung sowie den Ausführungsbeispielen entnehmen.

Der vorgeschlagene Operationsverstärker weist wenigstens eine erste Verstärkerschaltung in einem Hauptsignalpfad von Eingangsanschlüssen zu einem oder zwei Ausgangsanschlüssen des Operationsverstärkers auf. Vom Hauptsignalpfad zweigt an oder zwischen den Eingangsanschlüssen und der ersten Verstärkerschaltung ein Nebensignalpfad ab, in dem eine zweite Verstärkerschaltung ausgebildet ist. Der Nebensignalpfad wird in der ersten Verstärkerschaltung wieder mit dem Hauptsignalpfad zusammengeführt. Die erste und die zweite Verstärkerschaltung sind dabei so dimensioniert, dass die Signalbandbreite des Hauptsignalpfades um einen Faktor von mindestens 10 größer als die Signalbandbreite des Nebensignalpfades ist und die zweite Verstärkerschaltung einen geringeren Eingangs-Offset als die erste Verstärkerschaltung aufweist. Die Begriffe Hauptsignalpfad und Nebensignalpfad werden dabei lediglich zur Unterscheidung zwischen den beiden Signalpfaden eingesetzt, ohne hierdurch weitere Eigenschaften dieser Signalpfade festzulegen.

Bei dem vorgeschlagenen Operationsverstärker kann somit durch geeignete Dimensionierung der zweiten Verstärkerschaltung ein geringer Eingangs-Offset erreicht werden, da die zweite Verstärkerschaltung nicht auf eine hohe Signalbandbreite ausgelegt werden muss. Die Transistoren der zweiten Verstärkerschaltung können daher geometrisch sehr groß dimensioniert werden. Da der Nebensignalpfad relativ zum Hauptsignalpfad nur sehr langsam arbeitet, kann er trotz der großen Transistoren auch mit sehr geringem Stromverbrauch (wenige µA) ausgelegt werden. Der geringe Eingangs-Offset der zweiten Verstärkerschaltung wird an den Gesamtverstärker vererbt, sodass der Operationsverstärker dann ebenfalls eine kleine eingangsbezogene Offset-Fehlerspannung aufweist. Die Transistoren der ersten Verstärkerschaltung im Hauptsignalpfad können hingegen geometrisch klein gewählt werden, um die gegenüber dem Nebensignalpfad hohe Signalbandbreite und damit Schnelligkeit bei ebenfalls geringer Leistungsaufnahme zu gewährleisten.

Vorzugsweise werden die erste und die zweite Verstärkerschaltung dabei so dimensioniert, dass die zweite Verstärkerschaltung einen um den Faktor von mindestens 5 geringeren Eingangs-Offset als die erste Verstärkerschaltung aufweist. Dies wird in bekannter Weise durch geeignete Wahl der Größe der Kanal- bzw. Gate- oder Emitter-Fläche der Transistoren in der zweiten Verstärkerschaltung erreicht.

Der vorgeschlagene Operationsverstärker lässt sich somit als schneller Verstärker mit geringer Leistungsaufnahme bei gleichzeitig kleiner eingangsbezogener Offset-Spannung realisieren, welcher keine Taktansteuerung für ein Offset-Sampling benötigt, sondern rein zeitkontinuierlich arbeitet. Damit eignet sich dieser Operationsverstärker für schnelle Regelschleifen bei nur kleiner statischer Regelabweichung.

In einer bevorzugten Ausgestaltung weist der Operationsverstärker im Hauptsignalpfad zwischen der ersten Verstärkerschaltung und dem oder den Ausgangsanschlüssen noch eine weitere Verstärkerschaltung auf, in der vorliegenden Patentanmeldung als dritte Verstärkerschaltung bezeichnet. Die zweite Verstärkerschaltung ist vorzugsweise als zweistufiger Verstärker ausgebildet.

Die Verstärkerschaltungen lassen sich bei dem vorgeschlagenen Operationsverstärker in unterschiedlicher Weise realisieren. So kann die erste Verstärkerschaltung beispielsweise Feldeffekttransistoren oder Bipolartransistoren als verstärkende Transistoren aufweisen. Einige dieser Transistoren (hier als erste Transistoren bezeichnet) sind dabei Eingangstransistoren der ersten Verstärkerschaltung und bilden einen ersten Übertragungsleitwert. Die anderen Transistoren (hier als zweite Transistoren bezeichnet) bilden einen zweiten Übertragungsleitwert und sind so mit den ersten Transistoren verschaltet, dass die Drain- oder Kollektoranschlüsse der zweiten Transistoren mit den Drain- oder Kollektoranschlüssen die ersten Transistoren verbunden sind. Der Nebensignalpfad wird bei dieser Ausgestaltung an den Drain- oder Kollektoranschlüssen der ersten und zweiten Transistoren wieder mit dem Hauptsignalpfad zusammengeführt.

In einer besonders bevorzugten Ausgestaltung wird die erste Verstärkerschaltung durch FDSOI-MOSFETs (als verstärkende Transistoren) gebildet. Der Nebensignalpfad wird in dieser Ausgestaltung an den Drainanschlüssen der FDSOI-MOSFETs wieder mit dem Hauptsignalpfad zusammengeführt. Dies führt zu einem sehr übersichtlichen einfachen Schaltungsaufbau.

### Kurze Beschreibung der Zeichnungen

Der vorgeschlagene Operationsverstärker wird nachfolgend anhand von Ausführungsbeispielen in Verbindung mit den Zeichnungen nochmals kurz erläutert. Hierbei zeigen:
- Fig. 1: ein Blockschaltbild des vorgeschlagenen Operationsverstärkers gemäß einer Ausgestaltungsvariante;
- Fig. 2: einen beispielhaften Schaltplan für eine erste Ausgestaltung des vorgeschlagenen Operationsverstärkers;
- Fig. 3: einen beispielhaften Schaltplan für eine zweite Ausgestaltung des vorgeschlagenen Operationsverstärkers;
- Fig. 4: einen beispielhaften Schaltplan für eine dritte Ausgestaltung des vorgeschlagenen Operationsverstärkers;
- Fig. 5: einen beispielhaften Schaltplan für eine vierte Ausgestaltung des vorgeschlagenen Operationsverstärkers; und
- Fig. 6: einen beispielhaften Schaltplan für die zweite Verstärkerschaltung.

### Wege zur Ausführung der Erfindung

Mit der vorliegenden Erfindung lässt sich ein schneller Operationsverstärker mit geringer Leistungsaufnahme und gleichzeitig kleiner eingangsbezogener Offset-Spannung realisieren. Der Operationsverstärker zeichnet sich durch einen zweiten Signalpfad (Nebensignalpfad) neben dem Hauptsignalpfad aus, der an oder zwischen den Eingangsanschlüssen des Operationsverstärkers und der ersten Verstärkerschaltung vom Hauptsignalpfad abzweigt und in der ersten Verstärkerschaltung wieder mit dem Hauptsignalpfad zusammengeführt wird. Eine zweite Verstärkerschaltung im zweiten Signalpfad, hier als Nebensignalpfad bezeichnet, wird mit einem kleinen Eingangs-Offset bei deutlich geringerer Signalbandbreite als im Hauptsignalpfad realisiert. Der Hauptsignalpfad kann hingegen auf hohe Schnelligkeit (große Signalbandbreite) hin ausgelegt werden. Unter einem kleinen Eingangs-Offset wird dabei vorzugsweise ein Eingangs-Offset verstanden, der mindestens 5 mal kleiner als der Eingangs-Offset an der ersten Verstärkerschaltung ist, beispielsweise 1 mV bei einem Eingangs-Offset von 5-10 mV am Eingang des Hauptsignalpfades.

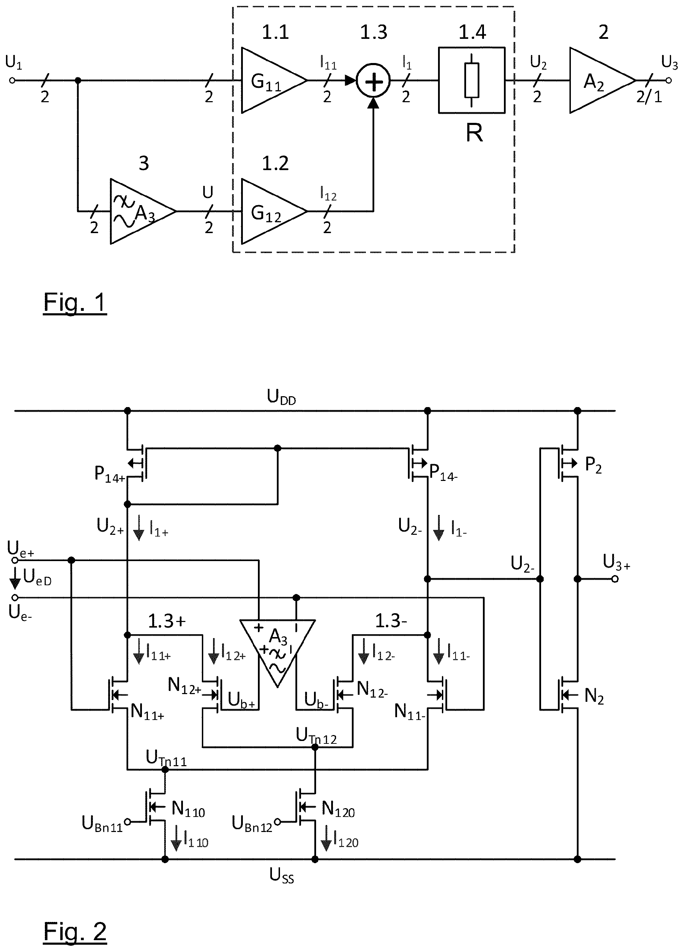

Figur 1 zeigt ein Blockschaltbild eines derartigen Operationsverstärkers in einer möglichen Ausgestaltungsvariante, bei der der Operationsverstärker zwei kaskadierte Verstärkerstufen mit Spannungsverstärkungen aufweist. Eine an den Eingangsanschlüssen angelegte Spannung U₁ wird über die erste Verstärkerschaltung 1.1 - 1.4 auf die Spannung U₂ und schließlich durch die zweite Verstärkerstufe 2 (hier auch als dritte Verstärkerschaltung bezeichnet) auf die Ausgangsspannung U₃ verstärkt. Die Spannungsverstärkungen in diesem Hauptsignalpfad (über 1.1, 1.3, 1.4 und optional 2) betragen A₁₁ = G₁₂*R und A₂, wobei A die Spannungsverstärkung, G den Übertragungsleitwert (Transkonduktanz) und R den Widerstand der Lastschaltung repräsentieren. Die Verstärkerschaltungen in diesem Hauptsignalpfad sind breitbandig und damit als schnelle Verstärker ausgebildet. G₁₁ hat aufgrund der Dimensionierung auf große Geschwindigkeit und geringe Leistungsaufnahme flächenmäßig kleine Transistoren und damit eine relativ große eingangsbezogene Offset-Fehlerspannung. Zwischen den Eingangsanschlüssen des Operationsverstärkers und der ersten Verstärkerschaltung 1.1 - 1.4 zweigt ein Nebensignalpfad (über 3, 1.2, 1.3, 1.4 und optional 2) mit einer zweiten Verstärkerschaltung 3 ab, die auf eine relativ kleine eingangsbezogene Offset-Fehlerspannung hin dimensioniert ist. Dieser Nebensignalpfad wird in der ersten Verstärkerschaltung 1.1 - 1.4 wieder mit dem Hauptsignalpfad zusammengeführt, wie dies an dem Knoten 1.3 in dem Blockschaltbild der Figur 1 zu erkennen ist. Die zweite Verstärkerschaltung 3 ist dabei auf eine geringe Bandbreite hin dimensioniert, weist also flächenmäßig große Transistoren auf. Der Nebensignalpfad ist damit gegenüber dem Hauptsignalpfad ein schmalbandiger langsamer Pfad, der eine Spannungsverstärkung von A₁₂ = A₃*G₁₂*R aufweist.

Durch diese Realisierung des Operationsverstärkers ist dieser im Hauptsignalpfad schnell bzw. breitbandig und schwingt trotzdem auf die kleine Offset-Fehlerspannung des langsamen Nebensignalpfades ein. Die Bezugszeichen 1.1 und 1.2 stellen hierbei Transkonduktanzen bzw. Übertragungsleitwerte, das Bezugszeichen 1.3 einen Knoten, an dem die Kirchhoffsche-Knotenregel gilt, und Bezugszeichen 1.4 eine Lastschaltung dar. Die Spannungen sind mit U, die Ströme mit I bezeichnet.

Der vorgeschlagene Operationsverstärker, wie er in Figur 1 beispielhaft im Blockschaltbild dargestellt ist, lässt sich in unterschiedlichen Varianten, insbesondere mit unterschiedlichen Transistorarten, realisieren. Figur 2 zeigt hierzu einen beispielhaften Schaltplan einer ersten Ausgestaltungsvariante mit Bulk-n-Kanal-MOSFET-Transkonduktanz (TK), p-Kanal-MOSFET-Lastschaltung (R) und CMOS-Inverter. Die Transkonduktanz (TK) G₁₁ der ersten Verstärkerschaltung wird dabei durch das Differenzpaar N_{11+/-} und die Fußpunktstromquelle N₁₁₀ realisiert. Die Transkonduktanz G₁₂ wird durch das Differenzpaar N_{12+/-} und die Fußpunktstromquelle N₁₂₀ realisiert. Die Lastschaltung R wird durch die Feldeffekttransistoren P_{14+/-} mit differenziell-nach-unipolar-Funktion gebildet. Die zweite Verstärkerstufe 2 bzw. A₂ wird durch den CMOS-Inverter P₂+N₂ realisiert.

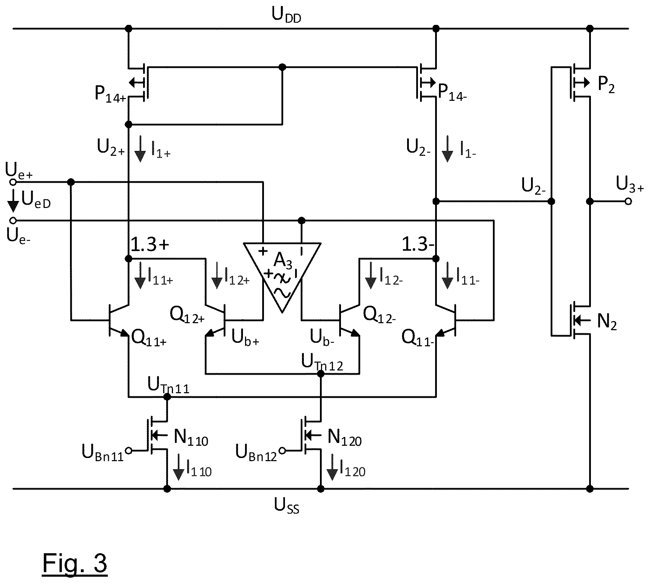

Figur 3 zeigt einen beispielhaften Schaltplan einer zweiten Ausgestaltungsvariante mit npn-BJT-Transkonduktanz, p-Kanal-MOSFET-Lastschaltung und CMOS-Inverter. Im Unterschied zur ersten Ausgestaltungsvariante der Figur 2 werden hier also keine MOSFETs sondern Bipolartransistoren in der ersten Verstärkerschaltung eingesetzt. Die Transkonduktanz G₁₁ der ersten Verstärkerschaltung wird dabei wieder durch das Differenzpaar N_{11+/-} und die Fußpunktstromquelle N₁₁₀ realisiert. Die Transkonduktanz G₁₂ wird durch das Differenzpaar Q_{12+/-} und die Fußpunktstromquelle N₁₂₀ realisiert. Die Lastschaltung R wird durch die Feldeffekttransistoren P_{14+/-} mit differenziell-nach-unipolar-Funktion gebildet. Die zweite Verstärkerstufe 2 bzw. A₂ wird durch den CMOS-Inverter P₂+N₂ realisiert.

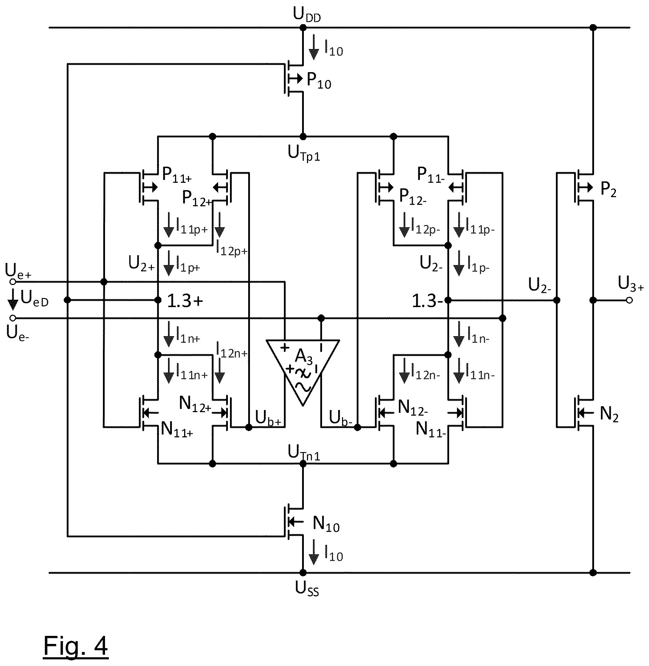

Figur 4 zeigt einen beispielhaften Schaltplan einer dritten Ausgestaltungsvariante mit Bulk-CMOS-Transkonduktanz- und Lastschaltung und CMOS-Inverter. Die Transkonduktanz G₁₁ und die Last(teil) schaltung R₁₁ werden in dieser Ausgestaltung durch die Differenzpaare N/P_{11+/-}, die Transkonduktanz G₁₂ und die Last(teil)-schaltung R₁₂ durch die Differenzpaare N/P_{12+/-}realisiert. N₁₀ und P₁₀ stellen die gemeinsamen Fußpunktstromquellen dar. Die differenzial-nach-unipolar-Funktion ist bei dieser Schaltung implizit vorhanden. Die zweite Verstärker-stufe 2 bzw. A₂ wird wiederum durch den CMOS-Inverter P₂+N₂ gebildet.

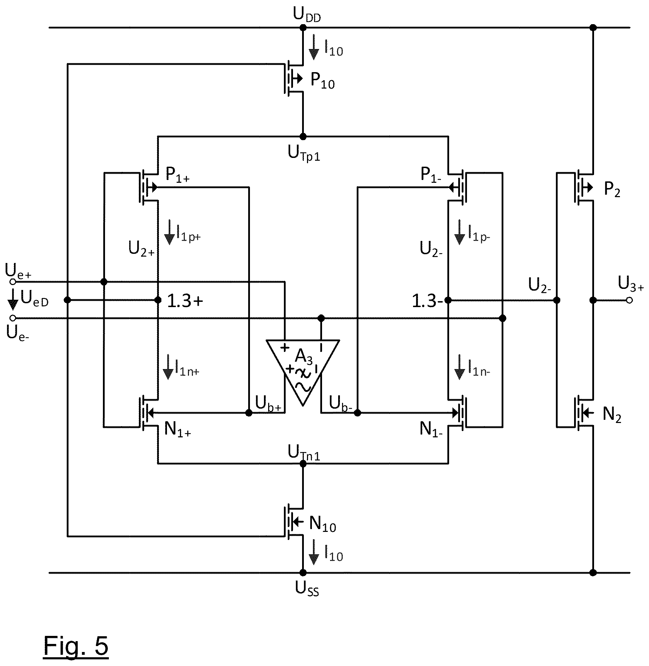

Figur 5 zeigt schließlich einen beispielhaften Schaltplan einer vierten Ausgestaltungsvariante mit FDSOI-CMOS-Transkonduktanz- und Lastschaltung und CMOS-Inverter. Bei dieser besonders vorteilhaften Ausgestaltung werden die Transkonduktanz G₁₁, die Transkonduktanz G₁₂ und die Lastschaltung R durch die Differenzpaare N/P_{1+/-} realisiert, wobei G₁₁ über die Ansteuerung am Gate und G₁₂ über die Ansteuerung am Backgate umgesetzt werden. Auch hier werden gemeinsame Fußpunktstromquellen N/P₁₀ eingesetzt, die differenzial-nach-unipolar-Funktion ist wiederum implizit vorhanden. Auch die zweite Verstärkerstufe 2 bzw. A₂ wird wiederum durch den CMOS-Inverter P₂+N₂ gebildet. Bei dieser Ausgestaltung wird somit der parallele, offsetarme langsame Signalpfad (Nebensignalpfad) an den Backgates der FDSOI-Eingangs-MOSFETs im Hauptsignalpfad der ersten Verstärkerschaltung wieder mit dem Hauptsignalpfad zusammengeführt. Bei allen obigen Ausgestaltungsvarianten stellt U_{eD} die Eingangsspannung und U₃₊ die Ausgangsspannung dar.

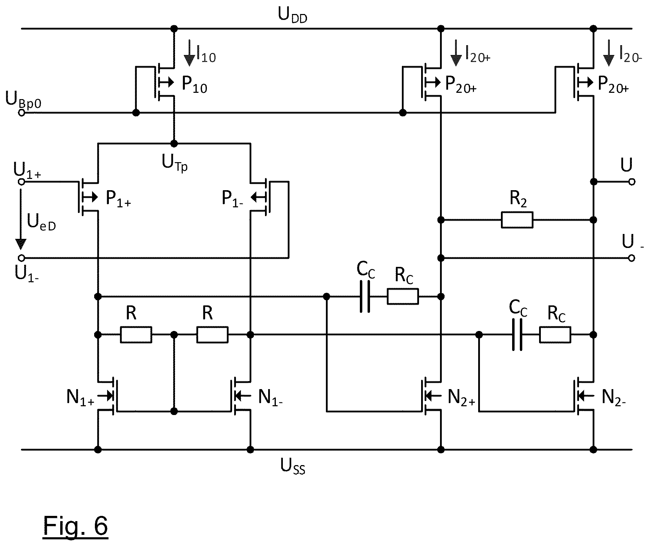

Figur 6 zeigt schließlich einen beispielhaften Schaltplan für die Umsetzung der zweiten Verstärkerschaltung 3 bzw. A₃ im Nebensignalpfad. Es handelt sich hierbei um einen zweistufigen Operationsverstärker. Die erste Stufe setzt sich aus der Fußpunktstromquelle P₁₀, dem Differenzpaar P_{1+/-}, den Last-MOSFETs N_{1+/-} und der Gleichtaktregelung über R_{∞} zusammen. Die zweite Stufe wird durch das Pseudo-Differenzpaar N_{2+/-}, die Last-MOSFETs/Stromquellen P_{20+/-} und die Lastanpassung über R₂ gebildet. Die Kompensation bzw. Bandbreitenbegrenzung erfolgt über R_{C} C_{C}.

## Patentansprüche

1. Operationsverstärker, der wenigstens eine erste Verstärkerschaltung (1.1, 1.2, 1.3, 1.4) in einem Hauptsignalpfad von Eingangsanschlüssen zu einem oder zwei Ausgangsanschlüssen des Operationsverstärkers aufweist,
wobei vom Hauptsignalpfad an oder zwischen den Eingangsanschlüssen und der ersten Verstärkerschaltung (1.1, 1.2, 1.3, 1.4) ein Nebensignalpfad abzweigt, in dem eine zweite Verstärkerschaltung (3) ausgebildet ist und der in der ersten Verstärkerschaltung (1.1, 1.2, 1.3, 1.4) wieder mit dem Hauptsignalpfad zusammengeführt wird,
wobei die erste und die zweite Verstärkerschaltung (1.1, 1.2, 1.3, 1.4, 3) so dimensioniert sind, dass eine Signalbandbreite des Hauptsignalpfades um einen Faktor von mindestens 10 größer als eine Signalbandbreite des Nebensignalpfades ist und die zweite Verstärkerschaltung (3) einen geringeren Eingangs-Offset als die erste Verstärkerschaltung (1.1, 1.2, 1.3, 1.4) aufweist.

2. Operationsverstärker nach Anspruch 1,
**dadurch gekennzeichnet,**
**dass** die erste Verstärkerschaltung (1.1, 1.2, 1.3, 1.4) durch FDSOI-MOSFETs gebildet ist, wobei der Nebensignalpfad über Backgate-Anschlüsse der FDSOI-MOSFETs wieder mit dem Hauptsignalpfad zusammengeführt wird.

3. Operationsverstärker nach Anspruch 1,
**dadurch gekennzeichnet,**
**dass** die erste Verstärkerschaltung (1.1, 1.2, 1.3, 1.4) Feldeffekttransistoren oder Bipolartransistoren als verstärkende Transistoren aufweist, von denen erste Transistoren Eingangstransistoren der ersten Verstärkerschaltung (1.1, 1.2, 1.3, 1.4) sind und einen ersten Übertragungsleitwert (1.1) bilden und zweite Transistoren einen zweiten Übertragungsleitwert (1.2) bilden und so mit den ersten Transistoren verschaltet sind, dass Drain- oder Kollektoranschlüsse der zweiten Transistoren mit Drain- oder Kollektoranschlüssen der ersten Transistoren verbunden sind, damit der Nebensignalpfad über die Drain- oder Kollektoranschlüsse der ersten und zweiten Transistoren wieder mit dem Hauptsignalpfad zusammengeführt wird.

4. Operationsverstärker nach einem der Ansprüche 1 bis 3,
**dadurch gekennzeichnet,**
**dass** die erste und die zweite Verstärkerschaltung (1.1, 1.2, 1.3, 1.4, 3) so dimensioniert sind, dass die zweite Verstärkerschaltung (3) einen um einen Faktor von mindestens 5 geringeren Eingangs-Offset als die erste Verstärkerschaltung (1.1, 1.2, 1.3, 1.4) aufweist.

5. Operationsverstärker nach einem der Ansprüche 1 bis 4,
**dadurch gekennzeichnet,**
**dass** im Hauptsignalpfad zwischen der ersten Verstärkerschaltung (1.1, 1.2, 1.3, 1.4) und dem oder den Ausgangsanschlüssen eine dritte Verstärkerschaltung (2) angeordnet ist.

6. Operationsverstärker nach einem der Ansprüche 1 bis 5,
**dadurch gekennzeichnet,**
**dass** die zweite Verstärkerschaltung (3) als zweistufiger Verstärker ausgebildet ist.
